# EUROPEAN PATENT APPLICATION

(11) **EP 4 651 189 A1**
(43) Date of publication of application: **19.11.2025**
(21) Application number: 24175510.7
(22) Date of filing: 13.05.2024
(51) Int. Cl.: H01L 21/66, H01L 23/498, H01L 23/538, H01L 23/00

(54) **A METHOD FOR PRODUCING A RECEIVING SUBSTRATE FOR BONDING SEMICONDUCTOR DIES THERETO**

(71) Applicant: Imec VZW, 3001 Leuven (BE)
(72) Inventor: Derakhshandeh, Jaber, 3300 Tienen (BE); Beyne, Eric, 3001 Heverlee (BE)
(74) Representative: Patent Department IMEC

(57) **Abstract**

A receiving substrate (1) is produced, configured to receive thereon one or more dies (3) by hybrid bonding in one or more first landing areas (2a) and a one or more dies (4) by solder bonding in a one or more second landing areas (2b). In the two types of landing areas, contact pads (29,35,36) are formed which are embedded in a dielectric layer (37,50) or a stack of dielectric layers (27,28), enabling hybrid bonding in the hybrid bonding landing areas. The contact pads in the solder landing areas are configured to receive solder material directly on said contact pads after bonding of the hybrid bonded dies, without requiring the formation of under bump metal pads. According to preferred embodiments, at least the solder contact pads comprise two layers (29a,29b), a bottom layer and a top layer, the bottom layer being formed of a material exhibiting slower intermetallic compound formation when reacting with solder than the material of the top layer. According to further embodiments, additional contact pads (71) are incorporated in a stack of dielectric material into which the hybrid and solder contact pads are embedded, in a manner that enables to reveal said additional contact pads (71) after hybrid and solder bonding. Said additional contact pads may be configured for electrical testing of bonded dies or dies within the receiving substrate, or for wire bonding of further dies.

## Description

### Field of the Invention

The present invention is related to semiconductor processing, in particular to methods for bonding individual semiconductor dies to a receiving substrate.

### State of the art.

In the semiconductor industry, a common procedure involves the bonding of semiconductor dies, i.e. individual semiconductor components such as integrated circuit chips, to a larger receiving substrate. The substrate can be a process wafer which itself contains a plurality of dies. One particular example concerns the bonding of individual dies to a portion of a wafer dedicated to serve as a so-called interposer chip designed to carry and interconnect a number of dies of different functionalities, while being itself connected to a further carrier such as a printed circuit board. Through-semiconductor via (TSV) connections are produced through the substrates such as interposer for realizing connections from the front side of the interposer to the back side.

The bonding of the dies realizes an electrical connection between contact pads on the dies and corresponding contact pads on the receiving substrate. Two major bonding methods can be distinguished to realize these connections: solder bonding and hybrid bonding. Solder bonded dies are bonded through solder bumps applied to either the die or the substrate prior to the bonding process. The solder has a lower melting point than the metal pads onto which it is applied, and forms an intermetallic compound with the metal of these pads during a dedicated thermal cycle applied during the bonding process. Solder bonding requires the formation of a metal contact pad onto the bonding surfaces, the so-called under bump metallization (UBM) pads. These UBM pads have a specific composition aimed at obstructing the consumption of underlying conductive structures by the solder material.

A second bonding technique that is widely applied is known as hybrid bonding. Here the die and the receiving substrate are processed in a manner to create corresponding dielectric bonding surfaces with metal contact pads embedded in said bonding surfaces. The bonding involves realizing a direct dielectric-to-dielectric bond between the dielectric bonding surfaces and a direct metal-to-metal bond between aligned contact pads on the two surfaces, under the influence of an annealing temperature and possibly a mechanical pressure.

In practice, not all chip types can be sourced as either hybrid bond or solder bond dies so that it is often required to apply different bonding techniques on the same receiving substrate. As hybrid bonding requires planarizing the totality of the receiving substrate, this bonding technique is applied first, i.e. one or more hybrid bond dies are bonded first, followed by bonding one or more solder bonded dies. This approach however requires process steps such as the plating of UBM pads on the receiving substrate, when the hybrid bonded dies are already bonded to the substrate, which may lead to process complexities and the potential damaging of the hybrid bonded dies.

### Summary of the invention

The invention is related to a method in accordance with the appended claims. According to the invention, a receiving substrate is produced, configured to receive thereon one or more dies by hybrid bonding in one or more first landing areas and one or more dies by solder bonding in a one or more second landing areas. In the two types of landing areas, contact pads are formed which are embedded in a dielectric layer or a stack of dielectric layers, enabling hybrid bonding in the hybrid bonding landing areas. The contact pads in the solder landing areas are configured to receive solder material directly on said contact pads after bonding of the hybrid bonded dies, without requiring the formation of under bump metal pads.

According to preferred embodiments, at least the solder contact pads comprise two layers, a bottom layer and a top layer, the bottom layer being formed of a material exhibiting slower intermetallic compound formation when reacting with solder than the material of the top layer.

According to further embodiments, additional contact pads are incorporated in a stack of dielectric material into which the hybrid and solder contact pads are embedded, in a manner that enables to reveal said additional contact pads after hybrid and solder bonding. Said additional contact pads may be configured for electrical testing of bonded dies or dies within the receiving substrate, or for wire bonding of further dies.

The invention is in particular related to a method for producing a receiving substrate suitable for bonding to said substrate a plurality of semiconductor dies to thereby electrically connect the dies to said substrate, the method comprising the steps of :
- providing a substrate, said substrate having an upper surface comprising a plurality of landing areas for receiving thereon said respective dies,
- producing a first dielectric layer on said upper surface and in each of said landing areas,
- producing via connections through said first dielectric layer, said via connections being connected to circuitry within the receiving substrate,
- planarizing said first dielectric layer and said via connections to a common level surface,
- producing a second dielectric layer or a stack of dielectric layers on said common level surface, wherein contact pads are embedded in said second dielectric layer or in said stack of dielectric layers, and wherein :
   ∘ said contact pads are configured so that in each landing area, a plurality of said contact pads are connected to respective via connections within said landing area,
   ∘ in at least one first landing area, the contact pads are configured to enable bonding a die to said first landing area by hybrid bonding,
   ∘ in at least one second landing area, the contact pads are configured to enable bonding a die to said second landing area by solder bonding, by applying a solder material directly to said contact pads.

According to an embodiment, at least the contact pads in the second landing area comprise a stack including a bottom layer and a top layer, the top layer being formed of a first material configured for receiving said solder material thereon, the bottom layer being formed of a second material different from the top layer material, the second material being configured to exhibit a slower intermetallic compound formation reaction with the solder material than the first material.

According to an embodiment, the contact pads in the first landing area also comprise a stack including a bottom layer and a top layer of different materials.

According to an embodiment, the contact pads in the first and second landing area are produced by a single set of processing steps so that the layers of said stack, but not necessarily the in-plane dimensions of the contact pads in the first and the second landing area are the same.

According to an embodiment, the material of the bottom layers of said stacks has a higher thermal expansion coefficient than the material of the top layers of said stacks.

According to an embodiment, the method further comprises, after planarizing said first dielectric layer and said via connections to said common level surface, and before producing said contact pads configured for hybrid and solder bonding :
- in one or more areas of the receiving substrate lying outside any of the landing areas, producing one or more additional contact pads embedded in an additional dielectric layer formed on said common level surface,
- planarizing the additional dielectric layer and the one or more additional contact pads to a common planarized level,
and wherein said contact pads configured for hybrid and solder bonding in the respective landing areas are embedded in a stack of dielectric layers comprising said additional dielectric layer at the bottom of said stack.

According to an embodiment, said one or more additional contact pads are suitable for testing of dies bonded to or included in the receiving substrate.

According to an embodiment, said one or more additional contact pads are suitable for bonding one or more further dies to the receiving substrate.

According to an embodiment, said additional contact pads are produced by the following steps :
- producing said additional dielectric layer on said common level surface,
- producing an opening through the full thickness of said additional dielectric layer, wherein one or more of said via connections are exposed on the bottom of said opening,
- depositing a layer of electrically conductive material conformally in said opening and on the additional dielectric layer, wherein the thickness of said layer of conductive material is essentially equal to the thickness of the additional dielectric layer.
- patterning the layer of electrically conductive material, so as to create the additional contact pad in said opening, wherein a gap remains between the additional contact pad and the sidewall of the opening,
- depositing a further dielectric layer, thereby filling the gap,
- planarizing the further dielectric layer to the level of the upper surface of the additional contact pad.
According to an embodiment, said electrically conductive material of the additional contact pads is aluminium.

### Brief description of the figures

Figures 1a and 1b illustrate a receiving substrate applicable in the method of the invention, with the indication of landing areas for hybrid bonding and for solder bonding.
Figures 2a-2b to 6a-6b illustrate a method according to a first embodiment, for producing two-layered contact pads both in a landing area for a hybrid die and in a landing area for a solder die.
Figures 7a-7b illustrate a method according to a second embodiment, not including two-layered contact pads in either of the landing areas.
Figures 8 to 15 illustrate a first method for producing two-layered contact pads embedded in dielectric material.
Figures 16 to 21 illustrate alternative methods for producing two-layered contact pads.
Figures 22a-22b to 28a-28b illustrate an embodiment wherein two-layered contact pads are formed in a solder die landing area and not in a hybrid die landing area.
Figures 29-39 illustrate an embodiment wherein additional buried test pads are produced in an area between a hybrid die landing area and a solder die landing area.
Figures 40-45 illustrate one particular method for producing a large embedded test pad in accordance with an embodiment of the invention.

### Detailed description of the invention

A number of embodiments will be described with some degree of detail hereafter. All references to materials and dimensions are strictly exemplary and do not limit the scope of the invention, said scope being determined only by the appended independent claims.

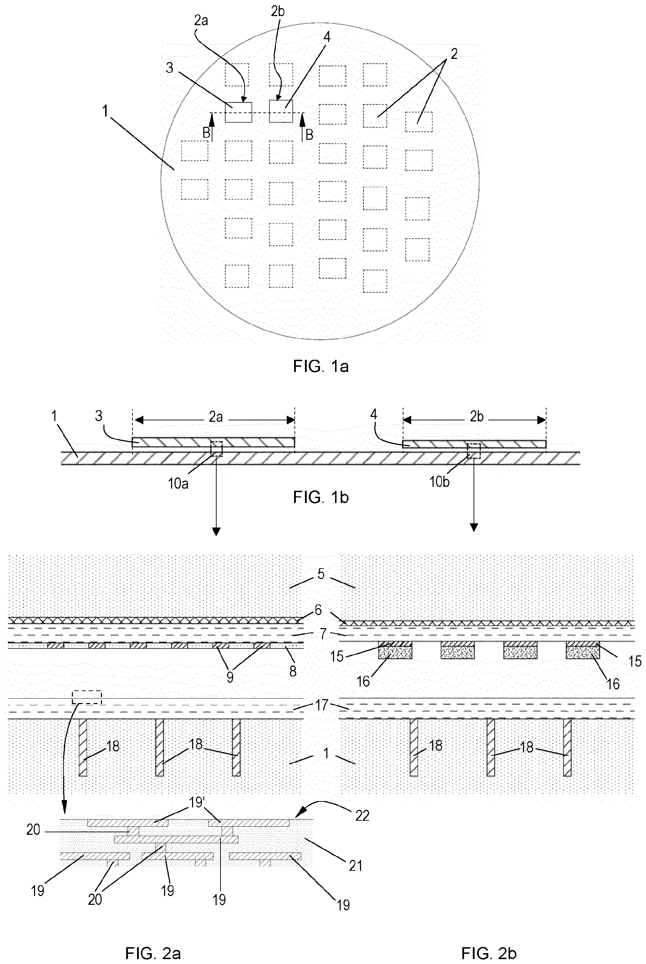

Figure 1a is a plane view of a receiving substrate, in this case a silicon wafer 1 comprising a plurality of landing areas 2 for receiving thereon individual semiconductor dies. Two dies 3 and 4 are shown aligned to respective landing areas 2a and 2b. The wafer 1 has undergone substantive processing steps in the landing areas 2, including at least the production of interconnect circuitry embedded in dielectric material, known also as a Back End of Line (BEOL) interconnect structure, that is accessible at the surface of the wafer (possibly after the removal of a passivation layer). Said interconnect circuitry may be connected to active semiconductor devices arranged in the Front End of Line (FEOL) portion of integrated circuit dies processed on the wafer, and/or to TSV (through semiconductor via) connections produced partly through the thickness of the wafer, to be exposed later by thinning the wafer from the back side. The dies 3 and 4 may be any one of a range of known semiconductor components, such as memory or logic type integrated circuit chips.

In the section view show in Figure 1b, the two semiconductor dies 3 and 4 are shown aligned (i.e. held at a distance but not yet bonded) to respective landing areas 2a and 2b. Each die may have in-plane dimensions in the order of a few millimetres for example, and a thickness in the order of a few tens to a few hundreds of micrometres. The aim is to place the dies onto the respective landing areas 2a and 2b by a pick-and-place tool and realize an electrically conductive bond between said dies and the receiving substrate 1 in the respective landing areas, wherein the first die 3 is to be bonded by hybrid bonding and the second die 4 is to be bonded by solder bonding. The embodiment described hereafter concerns a method for realizing these two different bonding techniques, enabled in particular by method steps which prepare the receiving substrate 1 in such a way that both bonding techniques are applicable without or with very limited process steps between hybrid bonding of the first die 3 and solder bonding of the second die 4. The first die 3 will hereafter also be referred to as the 'hybrid die', and the second die 4 as the 'solder die'.

Figures 2a and 2b show enlarged views of the rectangles 10a and 10b indicated in Figure 1b. These views each illustrate a small portion of the respective dies 3 and 4 and of the wafer 1 with the dies 3 and 4 aligned to the wafer 1 but prior to a number of preparation steps performed on the wafer. Both dies are seen to include a substrate portion 5, a FEOL portion 6 and a BEOL portion 7. The hybrid die 3 comprises a dielectric bonding layer 8 on the BEOL portion 7, with contact pads 9 embedded therein, said pads 9 being electrically connected to conductors of the BEOL portion 7. The surface of the dielectric bonding layer 8 and the contact pads 9 is planarized to a common level. Nevertheless, the contact pads 9 may be slightly recessed relative to the dielectric surface, which may be a consequence of the applied planarization technique. The solder die 4 comprises under bump metallization (UBM) pads 15 lying on the BEOL portion 7, said UBM pads 15 being electrically connected to conductors in said BEOL portion 7, and solder bumps 16 attached to said UBM pads 15.

The invention is characterized by method steps for preparing the receiving substrate 1, which facilitate the application of the two different bonding techniques on said substrate. These preparation steps will now be described according to a number of different embodiments of the invention.

In the landing areas 2a and 2b, the wafer 1 comprises a BEOL type circuitry portion 17 and a plurality of TSV connections 18 electrically connected to said BEOL portion 17 and extending partly through the thickness of the wafer 1. This part of the wafer is designed to serve as an interposer substrate, configured to receive a number of dies on its front side, which are to be connected to the opposite side of the interposer through the TSV connections. Said opposite side is to be processed after bonding of the dies on the front side and thinning the wafer from the back side to expose the TSVs. This is merely one example of a receiving substrate 1. According to other embodiments, the substrate may be configured differently, for example comprising FEOL and BEOL portions in each of the landing areas 2 and no TSV connections.

The upper surface of the BEOL portion 17 of the wafer 1 comprises electrical conductors embedded in a so-called IMD (intermetal dielectric) layer. A detail section view illustrates a possible layout of the upper region of the BEOL portion 17, including conductors 19 and vias 20 embedded in IMD material 21. The conductors 19' in the upper layer of the BEOL portion are accessible for being contacted in the upper surface 22 of said BEOL portion 17.

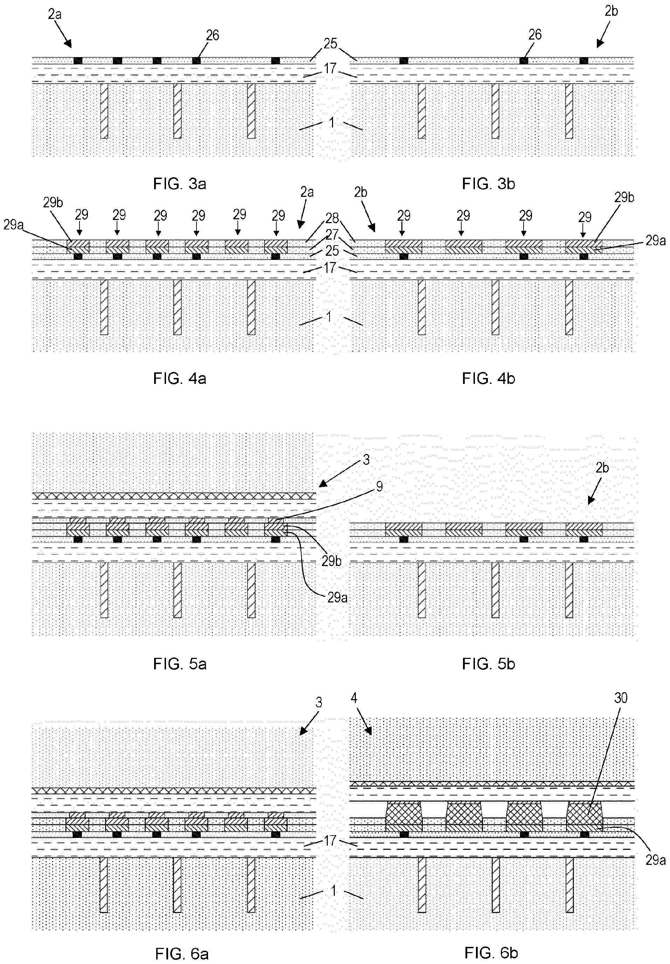

With reference to Figures 3a and 3b, a dielectric layer 25 is deposited on the upper surface of the BEOL portion 17, and via connections 26 are produced through said dielectric layer 25, at predefined locations, defined by the layout of the BEOL portion 17. The via connections 26 contact conductors in said upper BEOL surface 22 at said predefined locations. Producing the via connections 26 can be done by known methods, involving the formation of via-shaped cavities by lithography and etching, and the filling of said cavities with an electrically conductive material, for example copper, preferably preceded by lining the cavities with a suitable barrier layer and possibly a seed layer for enabling electrodeposition of Cu, as generally known in the art. The upper surface of the layer 25 is planarized by a known planarization technique such as chemical mechanical polishing (CMP), bringing the upper surface of the dielectric layer 25 and the via connections 26 to a common planar level. According to embodiments of the invention, the thickness of the dielectric layer 25 with the via connections 26 embedded therein as represented in Figures 3a and 3b, may be in the order of 500 nm.

Reference is now made to Figures 4a and 4b. A stack of dielectric layers 27,28 is formed on the planarized surface of layer 25, with metal contact pads 29 embedded in said stack 27,28. Various methods for producing contact pads 29 or equivalents thereto will be described further in this description. A first array of 'hybrid contact pads' 29 is formed in the landing area 2a for the hybrid die 3 (Fig. 4a) and a second array of 'solder contact pads' 29 is formed in the landing area 2b for the solder die 4 (Fig. 4b). All contact pads 29 may have an essentially circular cross-section as seen in a plane perpendicular to the plane of the drawings. In the example shown, the contact pads for the solder die 4 are somewhat larger than the pads for the hybrid die 3. However, the in-plane dimensions of the contact pads may be within a wide range, from a few micrometres to a few tens of micrometres depending on the type of dies that are to be bonded. The pads 29 are preferably arranged in rectangular arrays of constant pitch. The dimensions and pitch of these arrays of contact pads produced according to the invention may correspond to values known in the art for hybrid and solder bonding applications.

As seen in Figures 4a and 4b, the contact pads 29 for both the hybrid die (Fig. 4a) and the solder die (Fig. 4b) comprise two layers : a bottom layer 29a that is in direct contact with the upper surface of the planarized layer 25, and a top layer 29b whose upper surface is essentially co-planar with or slightly recessed with respect to the upper surface of the stack of dielectric layers 27,28. In both landing areas 2a and 2b (for the hybrid die and for the solder die), the bottom layer 29a of at least some of the contact pads is in direct electrical contact with respective via connections 26 embedded in the dielectric layer 25. As shown, some contact pads 29 may not be in contact with corresponding via connections 26. These contact pads are dummy pads, included for example for mechanical stability of the eventually bonded dies.

The top layer 29b (both in the hybrid landing area 2a and in the solder landing area 2b) is a layer formed of copper or another material suitable for forming a direct metal-to-metal bond with corresponding contact pads on the hybrid die in the hybrid landing area 2a. The bottom layer 29a is a layer formed for example of Ni or Co when the top layer 29b is a Cu layer. The material of the bottom layer 29a exhibits a slower intermetallic reaction speed with a solder material compared to the material of the top layer 29b. For example, when the bottom layer 29a is Ni, this Ni layer prevents fast interaction between a Sn solder bump applied to the top layer 29b and the Cu of the via connection 26 underneath the Ni layer 29a, and thereby prevents consumption of said via connection 26 by the solder. The Ni layer 29a thereby performs a similar function as the UBM metal pads applied in conventional solder bonding. The thickness of the two layers 29a and 29b is adapted to this functionality. For example, for contact pads having in-plane dimensions within a range of about 5 to 15 µm, the thickness of the two metal layers 29a and 29b may be between 0.5 and 1 µm, so that the thickness of the pads 29 as a whole (layer 29a + layer 29b) is situated between 1 and 2 µm.

The upper surface of the dielectric layer stack 27,28 is planarized to a level of planarity that renders said upper surface sufficiently planar to enable hybrid bonding of the hybrid die 3 to its dedicated landing area 2a. The result of the hybrid bonding step is illustrated in Figures 5a and 5b : the hybrid die 3 is bonded and connected to the receiving substrate (fig. 5a) by aligning and bonding the contact pads 9 of the die 3 to the contact pads 29 in the hybrid bonding area 2a, and realizing the dielectric-to-dielectric and metal-to-metal hybrid bond, while the solder landing area 2b is still free. This solder landing area 2b is however ready to receive the solder die immediately after the hybrid bonding step, i.e. no UBM pads or bumps need to be plated on the solder bonding surface while the hybrid die 3 is already there, because the two-layer contact pads 29 are directly suitable for receiving thereon a solder connection.

The latter is illustrated in Figures 6a and 6b. As seen in Figure 6b, the solder bumps 16 have merged with the top metal layer 29b (Cu) to form solder connections 30, but intermetallic compound formation does not substantially progress to the underlying Cu via connection 26, thanks to the presence of the underlying Ni layer 29a, which acts as a barrier for the intermetallic compound formation (other materials in stead of Ni can be used for this). The representation of the solder connections is merely schematic. The solder connections are not necessarily consuming all of the Cu in layer 29b and may consume some of the Ni of layer 29a, however not so much that all of the Ni is consumed. The solder bonding step is followed by deposition and curing of an underfill material, known as such in the art and not represented in the drawings.

Although the functionality of the two-layer contact pads 29a+29b is related primarily to the solder die, the contact pads for receiving the hybrid die 3 also have the two-layer structure in the embodiment shown. This is not a limitation of the invention in general however, and other embodiments will be described hereafter wherein the hybrid contact pads do not have the two-layer structure. Nevertheless, said two-layer structure may also have an advantage in the case of the hybrid die, although this may depend on the contact pad size and the materials applied for the bottom and top layers 29a and 29b. This advantage is related to the bulge-out effect that is known to occur during hybrid bonding. As suggested above, the planarization of the bonding surface often leaves hybrid bonding pads somewhat recessed with respect to the dielectric bonding surface. This can be a beneficial effect as it enables realizing first the dielectric-to-dielectric bond, and then the metal-to-metal bond, obtained by the metal pads expanding thermally towards each other during the hybrid bond annealing cycle. This thermal expansion is known as the bulge-out effect. The two-layer structure may be beneficial if the metal of the bottom layer 29a has a higher thermal expansion coefficient than the top layer 29b, so that the bottom layer further enhances the bulge-out effect.

A more significant advantage of producing both the solder contact pads and the hybrid contact pads as two-layer structures 29a+29b embedded in a dielectric layer stack 27,28 is that one or more hybrid dies 3 can be bonded, directly followed by the bonding of one or more solder dies 4, without any intermediate process steps, so also without including the preparation of landing pads suitable for solder bonding. Such landing pads for solder bonding are already integrated in the same dielectric stack 27,28 as the hybrid contact pads.

The latter advantage is in fact not directly related to the two-layer structure as such, but rather to the fact that both the hybrid contact pads and the solder contact pads are embedded in a dielectric layer stack 27,28, and that the solder contact pads, as they are produced within said stack, are ready to receive thereon a solder bump without requiring the application of UBM pads on top of the solder bonding surface. This is the main advantage of any embodiment of the invention, and this advantage may also be obtained without the two-layer structure for the contact pads.

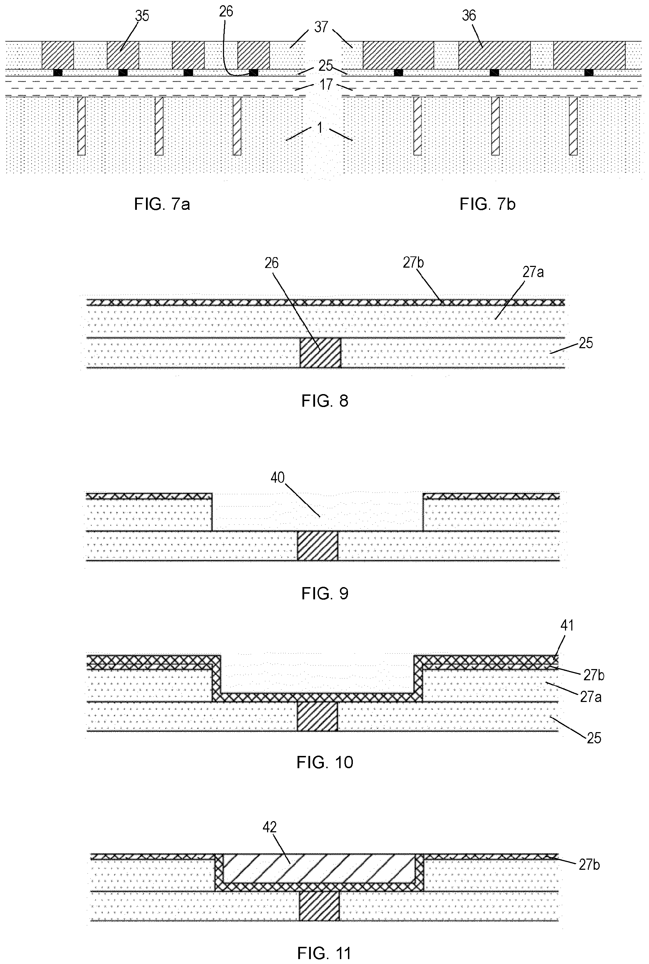

This is illustrated in Figures 7a and 7b. It is seen that the hybrid contact pads 35 and the solder contact pads 36 are formed of a single metal, for example Cu, and are both embedded in a single dielectric layer 37. The thickness of this layer and of the contact pads is higher than in the previous embodiment. This higher thickness is applied for the same reason as the Ni bottom layer 29a in the previous embodiment, avoiding the consumption of the Cu via connections 26 by solder material. This time it is the presence of more Cu in the solder contact pads 36 that ensures that the solder does not consume all of the contact pad. This solution is however not applicable for very small contact pad dimensions. On the other hand, the application of the two-metal structure 29a,29b of the contact pads for at least the solder contact pads does enable the production of very small contact pads (e.g. diameters of 5 micron or less) at small pitches in cost effective way.

According to an embodiment, additional contact pads (either two-layer contact pads 29a+29b or single-metal contact pads 35) are formed outside the hybrid landing area 2a, at the same level as the bonding pads. The additional contact pads are connected through the BEOL portion 17 to the bonding pads to which the hybrid die 3 is effectively bonded, and can thus be used for testing the connections between the pads on the hybrid die and the pads in the landing area 2a, after the hybrid bonding process. This testing procedure is different from a full functionality test of the die, for which specific test pads are typically required. An embodiment will be described later that incorporates such pads suitable for functional testing of the dies.

The two-layered contact pads 29 comprising a bottom layer 29a and a top layer 29b can be obtained in different ways, some of which will be described hereafter with reference to Figures 8 to 21. It will become apparent that the dielectric layers 27 and 28 as well as the sublayers 29a and 29b are not necessarily each formed of a single dielectric or metal layer.

A first method for producing a two-layered embedded contact pad 29 is described with reference to Figures 8 to 15. In a first step (Fig. 8), a first dielectric layer 27a is deposited on the planarized surface of layer 25, i.e. the dielectric layer 25 with contact vias 26 embedded therein, lying directly on the upper surface of the BEOL portion 17 (the latter is not shown in Figures 8-21). Layer 27a may be a silicon oxide layer of about 0.6 µm thick for example, obtainable by a known deposition method, for example CVD (chemical vapour deposition). A SiCN layer 27b of about 100 nm thick is then deposited on the layer 27a, to be used as a CMP stop layer later in the process. By standard lithography and etching, a via opening 40 is formed in the stack of layers 27a and 27b, as illustrated in Figure 9. The opening 40 may be formed by a timed etch that is stopped when the upper surface of the via connection 26 is exposed (a slight overetch is allowable here). Alternatively, layer 25 could be a stack of dielectric layers comprising for example a SiCN layer at the top, which can then serve as an etch stop layer in the etch process for forming the opening 40.

Then (Fig. 10) a barrier layer (not shown) and a Cu seed layer 41 are deposited one after the other and conformally, i.e. following the topography of the surface of the SiCN layer 27b and the bottom and sidewalls of the opening 40. The barrier layer may be a layer of TaN of about 10 nm thick. The seed layer 41 may be about 150nm thick. With reference to Figure 11, Ni or an equivalent material is then formed by electrodeposition on the seed layer 41, i.e. Ni grows upward from the seed layer, thereby filling the opening 40 with Ni. This is followed by a planarization step using standard grinding and/or CMP, stopping on the SiCN layer 27b, resulting in the image shown in Figure 11: a planarized Ni layer 42 fills the via opening, to act as the barrier for the intermetallic compound formation during soldering, as described above . Alternatively, the Ni layer could be formed by a technique other than electrodeposition, for example PVD (physical vapour deposition). In that case only the TaN barrier layer is deposited and the Ni layer is deposited directly on said barrier layer and thereafter planarized to the level of the SiCN layer 27b.

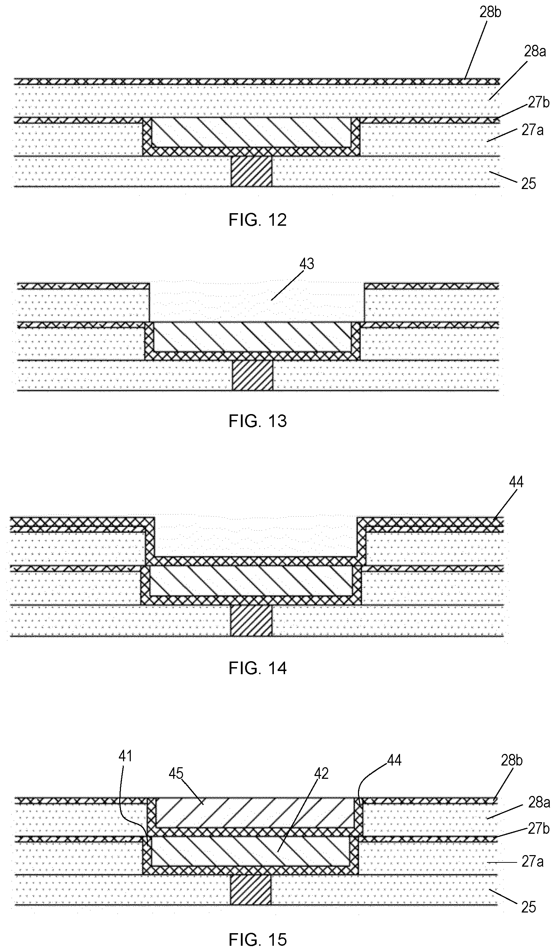

With reference to Figure 12, a second dielectric layer 28a, possibly another silicon oxide layer of about 0.6 µm thick, is deposited on the planarized surface of the first SiCN layer 27a, and a second SiCN layer 28b is deposited on the second dielectric layer 28a. A second via opening 43 is formed by standard lithography and etching, see Figure 13. The second opening is formed on top of and aligned to the first opening 40 and has essentially the same in-plane dimensions as the first opening. As small overlay error is allowed, as illustrated by the slight misalignment of the second via opening 43 relative to the first via opening 40. As illustrated in Figure 14, another seed layer 44 is deposited conformally in the second opening 43 and on the second SiCN layer 28b. This is followed by the electrodeposition of Cu on the second seed layer 44, and planarization to the level of the second SiCN layer 28b, resulting in the structure shown in Figure 15, i.e. comprising a planarized top Cu layer 45. This is therefore one embodiment of the two-layer contact pads 29 described above: the first layer 29a comprises the first seed layer 41 and the Ni layer 42 formed thereon, and the second layer 29b comprises the second seed layer 44 and the Cu layer 45 formed thereon. Layers 29a and 29b are embedded in a stack of dielectric layers 27 and 28, each comprising a silicon oxide layer (27a,28a) and a SiCN layer (27b,28b). The surface of the SiCN layer 28b is then the surface that will be bonded to the dielectric bonding surface of the hybrid die, which is then preferably also a SiCN bonding surface. The advantage of that approach is that a stronger bond is obtainable by SiCN-SiCN bonding than by oxide-oxide bonding.

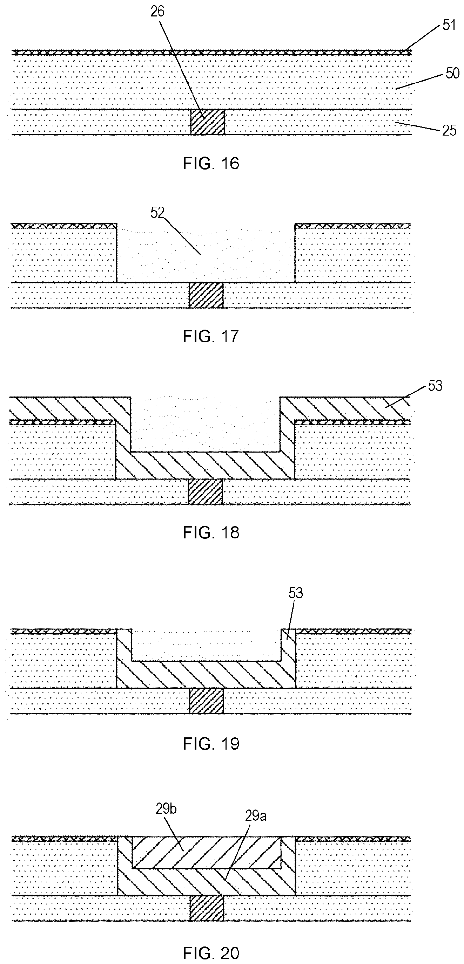

Another way of producing the two-layer contact pads 29 is illustrated with reference to Figures 16 to 20. A first dielectric layer 50, for example a silicon dioxide layer is deposited on the planarized surface of the layer 25 comprising the via connections 26, followed by the deposition of a SiCN layer 51. The dielectric layer 50 has about twice the thickness compared to the thickness of the layers 27a and 28a in the previous embodiment. The SiCN layer 51 may again have a thickness of about 100 nm. With reference to Figure 17, a via opening 52 is formed through the stack of layers 50 and 51. A barrier layer, for example 10nm TaN is deposited conformally (not shown), followed by (Fig. 18) the deposition of Ni by physical vapour deposition directly on the barrier layer. The Ni layer 53 is formed conformally in the via opening 52, i.e. a layer of Ni is formed on the bottom and the sidewalls of the (barrier layer in the) opening 52 and on the horizontal surface of the substrate. The thickness of the Ni layer 53 is about 0.5 µm. Then the Ni layer 53 is planarized to the level of the SiCN layer 51, as shown in Figure 19, followed by the deposition, again by PVD, of a layer of Cu. The Cu fills the remaining cavity having a height of about 0.5 µm left open by the conformal Ni deposition. A second planarization leads to the structure shown in Figure 20: the Cu top layer 29b is encapsulated laterally by upstanding Ni sidewalls extending upward from the Ni bottom layer 29a. This is another embodiment of the two-layer contact pads 29 produced in accordance with the invention.

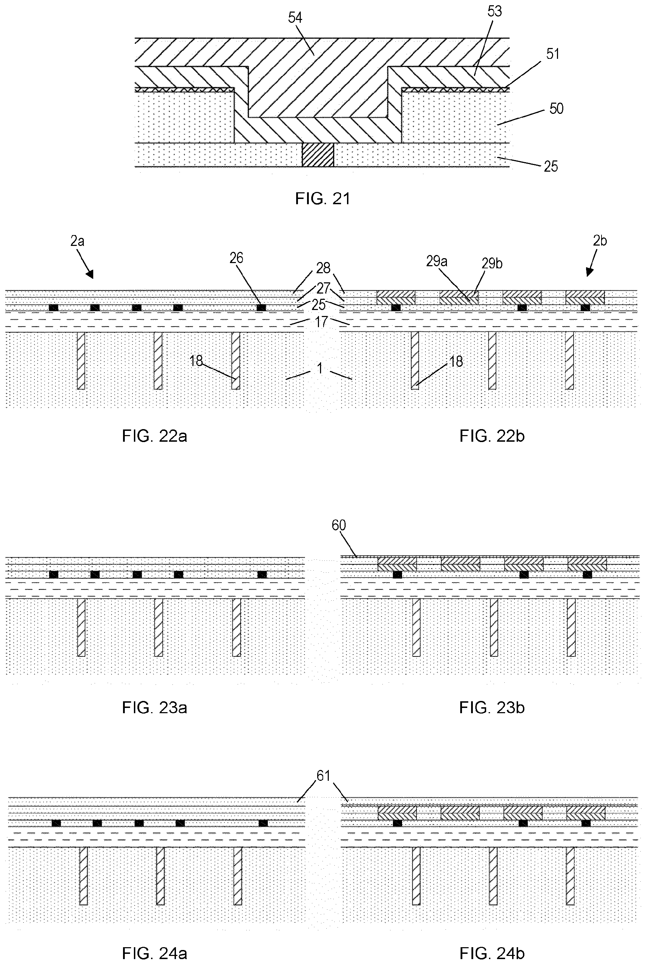

In an alternative to the last process flow, it is also possible to deposit a layer of Cu 54 on the conformal Ni layer 53 before planarizing said Ni layer. This is illustrated in Figure 21. This is then followed by planarization of both the Cu and the Ni to the level of the SiCN layer 51, leading to the same two-layer structure as shown in Figure 20. An advantage will be the oxide free interface between 53 and 54 layers as these layers can be deposited in single deposition step (i.e. without removing the substrate from the process chamber between depositions of layers 53 and 54).An embodiment is now described wherein the two-layer metal contact pads 29 are applied for receiving the solder bonded die 4, but not for the hybrid bonded die 3. Reference is made to Figures 22a and 22b. The stack of dielectric layers 27 and 28 is again formed on the surface of the planarized layer 25, but the two-layered metal pads 29 are formed only in the landing area 2b for the solder die (Fig. 22b), and not in the landing area 2a for the hybrid die (Fig. 22a).

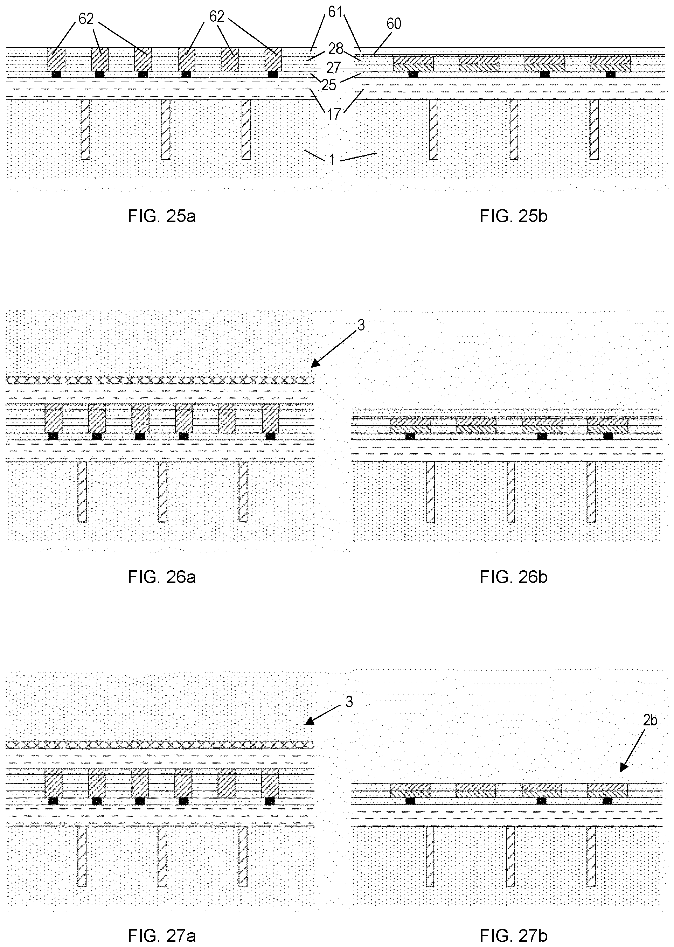

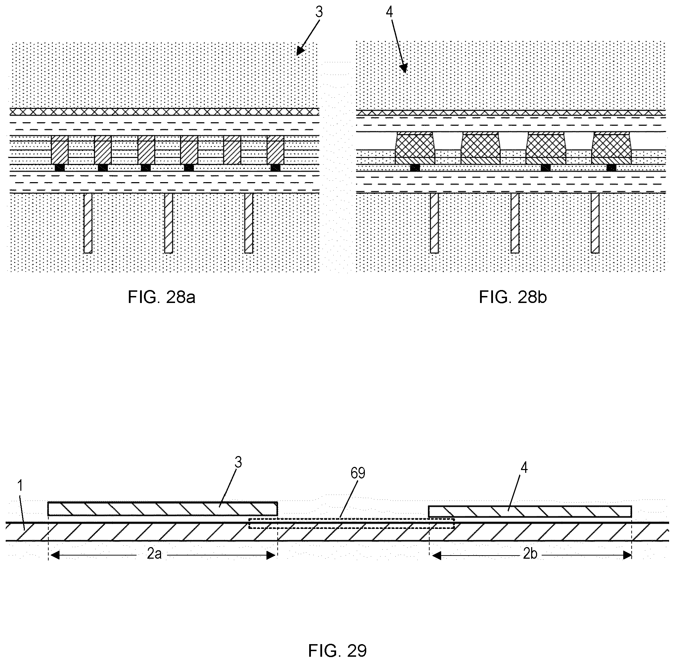

On the planarized surface of the layer stack 27+28, a thin protective layer 60 is then deposited and patterned (see Figures 23a and 23b), so that this layer 60 covers the landing area 2b for the solder die and not the landing area 2a for the hybrid die. Layer 60 may be a TiN layer for example, having a thickness of 10 nm. A further dielectric layer 61 (for example SiO₂) is deposited and planarized, see Figures 24a and 24b, obtaining a level surface across the full wafer 1. Layer 61 may have a thickness comparable to the thickness of layers 27 and 28. Thereafter, (Figures 25a and 25b), contact pads 62 are formed in the stack of dielectric layers 27,28,61, in the hybrid landing area 2a and the stack 27,28,61 is planarized. Hybrid bonding of the hybrid die 3 to these contact pads 62 is then performed (Figures 26a and 26b), followed by removing the dielectric layer 61 and the TiN layer 60 locally from the solder landing area 2b (Figures 27a and 27b). Following this, the solder die 4 is bonded to the solder landing area 2b (Figures 28a and 28b). The local removal of the dielectric layer 61 and the TiN layer 60 can be performed by lithography and etching, wherein the hybrid die 3 is protected by a mask layer that can be stripped after litho and etching, without posing a risk of damage to the hybrid die. This embodiment is therefore also beneficial through the fact that no steps are required after hybrid bonding which are potentially damaging to the hybrid bonded dies.

Reference is now made to Figures 29 to 36 which illustrate a further embodiment of the invention. According to this embodiment, additional buried contact pads are incorporated into the dielectric stack containing the hybrid bond pads and the solder bond pads described above. These additional contact pads are suitable as test pads for electrical testing of dies incorporated in the receiving substrate and/or for testing of dies bonded to said substrate, either by hybrid bonding or by solder bonding. The additional pads may also be suitable for bonding of further dies to the receiving substrate.

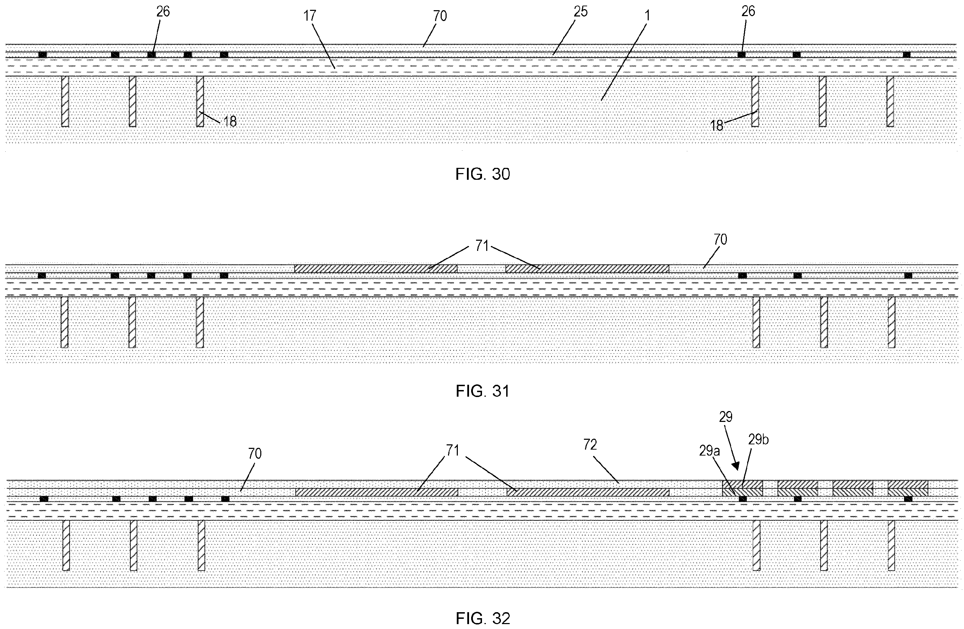

Figure 29 shows again the hybrid die 3 and the solder die 4 aligned to the receiving substrate 1 prior to bonding to the wafer 1. The area between the respective landing areas 2a and 2b and partly overlapping said landing areas is indicated by the rectangle 69, and represented in more detail in Figures 30-36. As shown in Figure 30, the dielectric layer 25 comprising the via connections 26 is formed, as already described in relation to the previous embodiments. On this layer 25, a further dielectric layer 70 is deposited, for example formed of SiO₂. Layer 70 has a thickness in the same order of magnitude as the thickness of the layer 25, for example between 300 and 500 nm. With reference to Figure 31, large aluminium test contact pads 71 are then formed, embedded in said dielectric layer 70. These test pads are large compared to the hybrid contact pads and solder contact pads 29,35,36 described earlier. The test pads may for example have a square shape having sides of about 50 to 100 µm long. The test pads 71 are electrically connected to the circuitry of the BEOL portion 17, through via connections 26 in layer 25. The actual via connections 26 connecting the pads 71 to the BEOL portion 17 are lying outside the plane of the drawing.

A preferred way of producing the test pads 71 will be described further in this description, but the description of the process flow after the creation of these test pads will be completed first. This process flow is in fact similar to the process flows described earlier in this description, for producing embedded contact pads for hybrid and solder bonding.

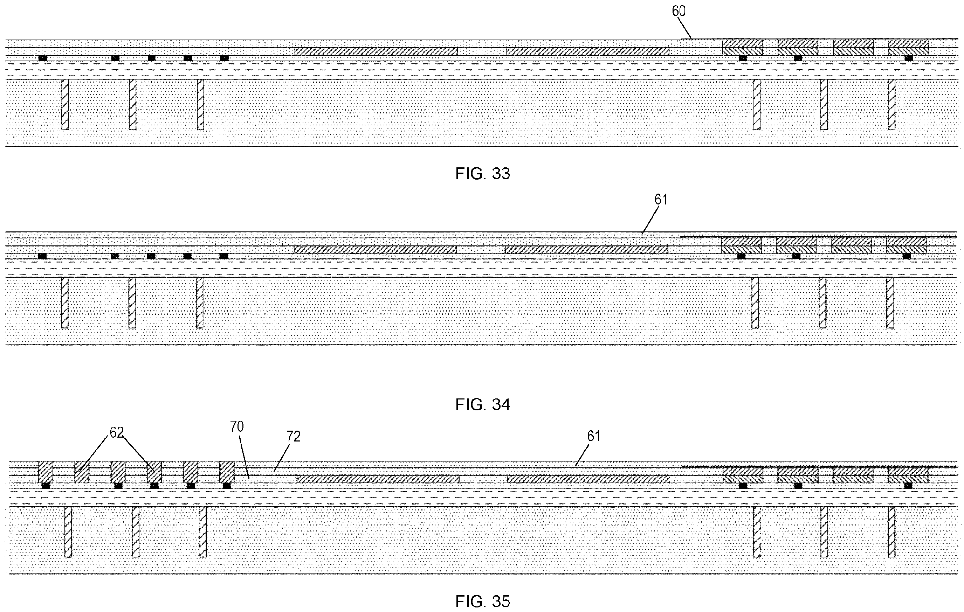

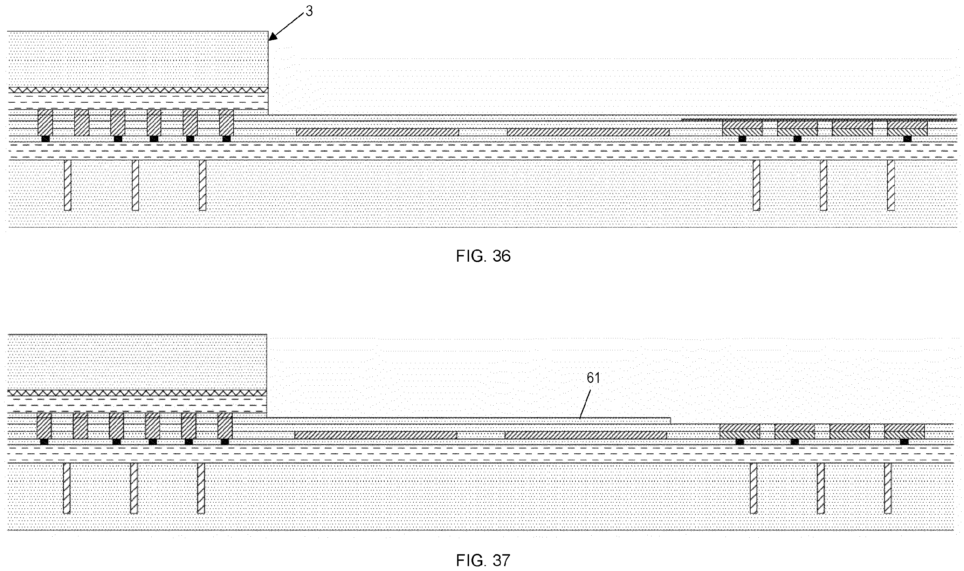

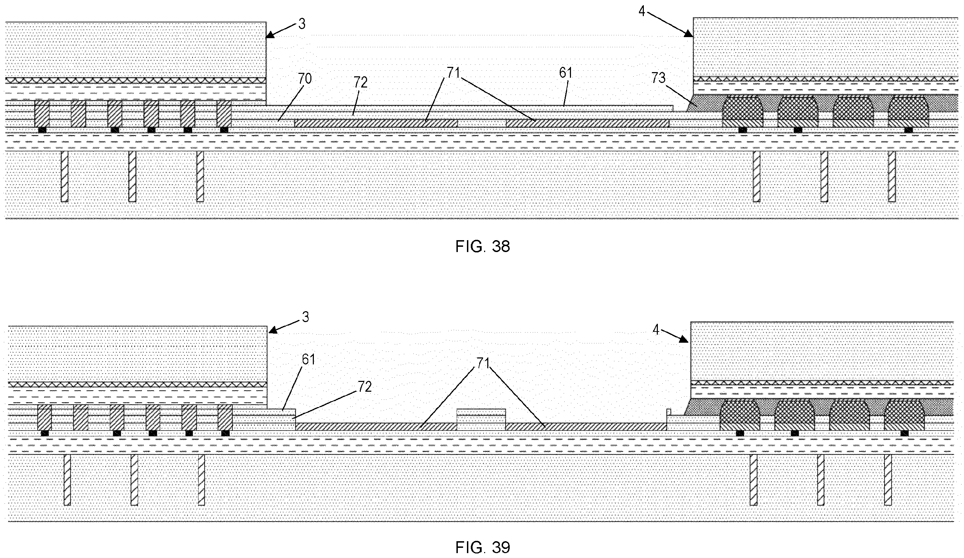

In this particular example, and as illustrated in Figure 32, two-layered solder bonding pads 29 (i.e. comprising layers 29a+29b) are formed in the solder landing area 2b. To this aim, a further dielectric layer 72 having a similar thickness to layer 70 is produced on layer 70, and the two-layered bonding pads 29 are formed in the stack 70+72 which may be done in accordance with any of the embodiments described with reference to Figures 8-15. The solder landing area 2b is covered by a TiN protective layer 60 (Figure 33), followed by the formation of an additional dielectric layer 61 (Figure 34) and of hybrid bonding pads 62 embedded in the stack of layers 70,72,61 (Figure 35), and planarization of said stack. This enables the hybrid bonding step, illustrated in Figure 36, followed by the opening of the solder landing area 2b (Figure 37) and solder bonding of the solder die 4 and application of under fill material 72 (Figure 38).

As stated, the hybrid bonding pads 62 are embedded in a stack of dielectric layers 70,72,61, whereas the solder bonding pads 29 are embedded in a stack of dielectric layers 70,72. Therefore, in embodiments which include the buried test pads 71 embedded in additional dielectric layer 70, the hybrid and solder bonding pads are embedded in a stack of dielectric layers with said layer 70 at the bottom of said stack.

As illustrated in Figure 39, the dielectric layers 72 and 61 may then be locally opened, to enable access to the test pads 71, for electrical testing of the hybrid die 3 and/or the solder die 4.

The aluminium test pads 71 are buried in a stack of dielectric layers 70,72,61 into which also the hybrid contact pads 62 in the hybrid landing area 2a and the solder contact pads 29 in the solder landing area are embedded. This enables testing of the bonded dies 3 and 4 simply by opening up the stack after bonding of the dies. This is contrary to the presently applied approach wherein test pads are plated onto the receiving substrate after bonding of dies by hybrid or solder bonding.

The use of aluminium for the test pads is merely exemplary and other materials may be applied. Contact pads of these large dimensions are applicable not only as test pads for electrical testing but also as contact pads for wire bonding. In the latter case, Al contact pads may be produced in separate dedicated landing areas for wire-bonded dies, to be bonded to the receiving substrate for example after bonding a number of dies 3 by hybrid bonding and a further number of dies 4 by solder bonding. Apart from wire bonding, the Al pads could serve as a base for receiving microbumps thereon, for bonding to another substrate.

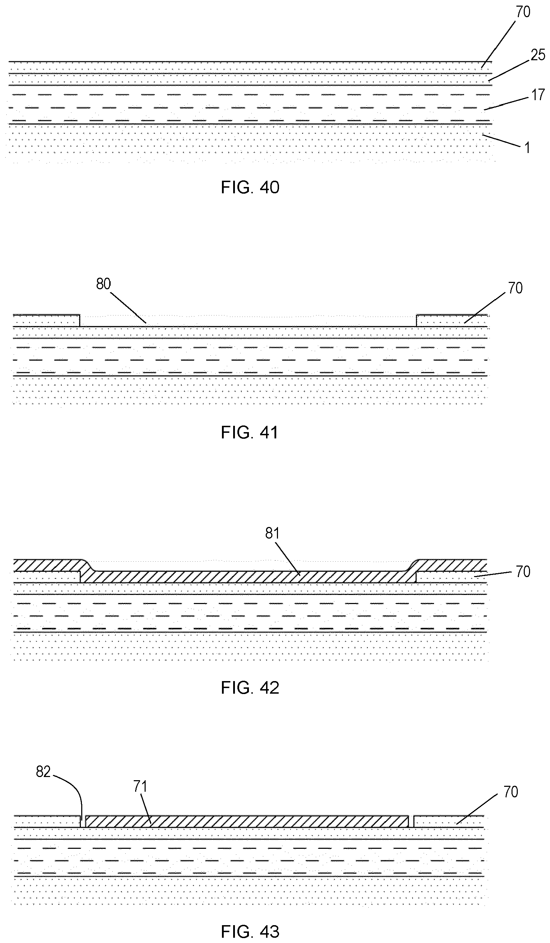

One detailed description of a possible method for producing in particular aluminium test or wire bonding pads according to the invention is described with reference to Figures 40 to 45. Figure 40 shows a portion of the wafer 1, the BEOL portion 17, the dielectric layer 25 and the planarized dielectric layer 70 formed thereon. Figure 41 shows the formation of an opening 80 by litho and etching of layer 70. At the bottom of the opening 80, one or more via connections 26 (lying outside the plane of the drawing) are exposed and available for contacting by the Al bonding pad 71.

Then the Al is deposited, filling the opening 80 and forming a conformal layer 81 of Al on the layer 70 (Fig. 42). The thickness of the Al layer 81 is equal to or as close as possible to the thickness of the dielectric layer 70.

In the case of Al, two preliminary depositions (not shown) are done before depositing the Al layer 81 : first a thin TaN layer is deposited to prevent Cu diffusion from the Cu via connections 26. This is followed by a TiN deposition for improving the adhesion of the Al. Both these preliminary layers may be about 10 nm thick.

The layer 81 could be thinned by grinding and/or CMP, but this is difficult due to the large Al pad sizes, and time consuming in the case of Al and an alternative method is illustrated in Figure 43 : the Al layer is patterned by lithography and dry etching, so that Al remains only in the opening 80, except in a small gap 82 (for example having a width of about 1 µm depending on overlay accuracy of lithography tool) around the circumference of the opening 80.

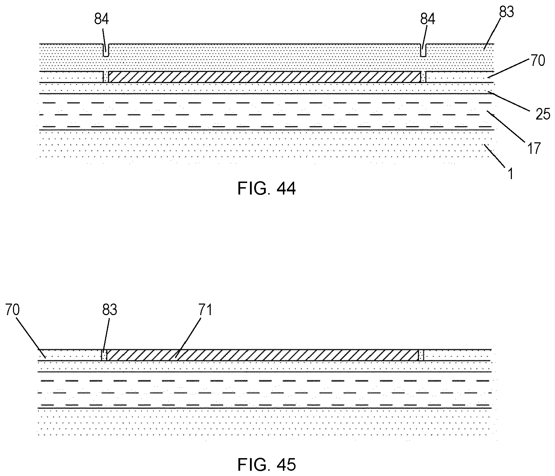

Then a further dielectric layer 83 is deposited (Figure 44), that fills the gap 82 and that is formed on the surface of the layer 70. This dielectric layer 83 can be a standard PECVD (plasma enhanced chemical vapour deposition) oxide layer or a spin on glass type of oxide layer. The dielectric layer fills the gap 82 conformally, so that a depression 84 is formed at the gap location. The thickness of the layer 83 is high enough so that the bottom of the depression 84 lies above the upper surface of the Al pad 71. Planarization finally results in the image shown in Figure 45 : the Al test pad 71 is fully embedded in a layer 70+83 of dielectric material.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for producing a receiving substrate suitable for bonding to said substrate a plurality of semiconductor dies (3,4) to thereby electrically connect the dies to said substrate, the method comprising the steps of:
- providing a substrate (1), said substrate having an upper surface comprising a plurality of landing areas (2a,2b) for receiving thereon said respective dies (3,4),
- producing a first dielectric layer (25) on said upper surface and in each of said landing areas,
- producing via connections (26) through said first dielectric layer, said via connections being connected to circuitry within the receiving substrate (1),
- planarizing said first dielectric layer (25) and said via connections (26) to a common level surface,
- producing a second dielectric layer (37,50) or a stack of dielectric layers (27,28;70,72,61 ;70,72) on said common level surface, wherein contact pads (29,35,36) are embedded in said second dielectric layer or in said stack of dielectric layers, and wherein :
∘ said contact pads are configured so that in each landing area (2a,2b), a plurality of said contact pads are connected to respective via connections (26) within said landing area,
∘ in at least one first landing area (2a), the contact pads are configured to enable bonding a die (3) to said first landing area by hybrid bonding,
∘ in at least one second landing area (2b), the contact pads are configured to enable bonding a die (4) to said second landing area by solder bonding, by applying a solder material directly to said contact pads.

2. The method according to claim 1, wherein at least the contact pads (29) in the second landing area (2b) comprise a stack including a bottom layer (29a) and a top layer (29b), the top layer being formed of a first material configured for receiving said solder material thereon, the bottom layer being formed of a second material different from the top layer material, the second material being configured to exhibit a slower intermetallic compound formation reaction with the solder material than the first material.

3. The method according to claim 2, wherein the contact pads (29) in the first landing area (2a) also comprise a stack including a bottom layer (29a) and a top layer (29b) of different materials.

4. The method according to claim 3, wherein the contact pads (29) in the first and second landing area are produced by a single set of processing steps so that the layers (29a,29b) of said stack, but not necessarily the in-plane dimensions of the contact pads (29) in the first and the second landing area (2a,2b) are the same.

5. The method according to any one of claims 2 to 4, wherein the material of the bottom layers (29a) of said stacks has a higher thermal expansion coefficient than the material of the top layers (29b) of said stacks.

6. The method according to any one of the preceding claims, further comprising, after planarizing said first dielectric layer (25) and said via connections (26) to said common level surface, and before producing said contact pads configured for hybrid and solder bonding :
- in one or more areas of the receiving substrate lying outside any of the landing areas, producing one or more additional contact pads (71) embedded in an additional dielectric layer (70) formed on said common level surface,
- planarizing the additional dielectric layer (70) and the one or more additional contact pads (71) to a common planarized level,
and wherein said contact pads configured for hybrid and solder bonding in the respective landing areas (2a,2b) are embedded in a stack of dielectric layers (70,72,61 ;70,72) comprising said additional dielectric layer (70) at the bottom of said stack.

7. The method according to claim 6, wherein said one or more additional contact pads (71) are suitable for testing of dies (3,4) bonded to or included in the receiving substrate (1).

8. The method according to claim 6 or 7, wherein said one or more additional contact pads (71) are suitable for bonding one or more further dies to the receiving substrate (1).

9. The method according to any one of claims 6 to 8 wherein said additional contact pads are produced by the following steps :
- producing said additional dielectric layer (70) on said common level surface,
- producing an opening (80) through the full thickness of said additional dielectric layer (70), wherein one or more of said via connections (26) are exposed on the bottom of said opening (80),
- depositing a layer (81) of electrically conductive material conformally in said opening (80) and on the additional dielectric layer (70), wherein the thickness of said layer (81) of conductive material is essentially equal to the thickness of the additional dielectric layer (70).
- patterning the layer (81) of electrically conductive material, so as to create the additional contact pad (71) in said opening (80), wherein a gap (84) remains between the additional contact pad (71) and the sidewall of the opening (80),
- depositing a further dielectric layer (83), thereby filling the gap (84),
- planarizing the further dielectric layer (83) to the level of the upper surface of the additional contact pad (71).

10. The method according to any one of claims 6 to 9, wherein said electrically conductive material of the additional contact pads (71) is aluminium.
